# EUROPÄISCHE PATENTANMELDUNG

(11) **EP 1 255 288 A2**
(43) Veröffentlichungstag der Anmeldung: **06.11.2002**
(21) Anmeldenummer: 02009028.8
(22) Anmeldetag: 23.04.2002
(51) Int. Cl.: H01L 21/304, H01L 23/48

(54) **Bauelement auf GaAs und Herstellungsverfahren**

(30) Priorität: 03.05.2001 DE 10121549
(71) Anmelder: Infineon Technologies AG, 81669 München (DE)
(72) Erfinder: Grambow, Peter, 80469 München (DE)
(74) Vertreter: Epping Hermann & Fischer

(57) **Zusammenfassung**

Ein Substrat (10) aus GaAs ist durch Dünnschleifen auf eine Dicke (d) von höchstens etwa 10 µm bis etwa 30 µm reduziert und besitzt Eigenschaften einer Folie, die ein Brechen des Substrates verhindern. Eine Metallisierung kann rückseitig auf das Substrat aufgebracht sein. Die thermischen Eigenschaften sind verbessert, da die Wärme besser auf die Rückseite des Substrates abgeführt werden kann. Die geringere Abmessung und die gute Wärmeableitung ermöglichen die Verwendung kleinerer Gehäuse. In das Substrat können äußerst kleine Löcher (micro via holes) geätzt und mit Kontaktlochfüllungen versehen sein.

## Beschreibung

Die vorliegende Erfindung betrifft Halbleiterbauelemente im Materialsystem von Galliumarsenid.

Halbleiterbauelemente, wie z. B. Transistoren, MMICs (modularly mounted integrated circuits), HBTs (Heterobipolartransistoren) oder HEMTs (high electron mobility transistors), im Materialsystem von GaAs sind seit langem bekannt. Von Nachteil ist, dass dieses Halbleitermaterial als Mischkristall extrem spröde ist und leicht bricht, so dass Substrate und gefertigte Bauelemente einer entsprechend vorsichtigen Handhabung bedürfen. Trotz entsprechender Maßnahmen ist bei der Herstellung von GaAs-Bauelementen die Ausbeute an funktionsfähigen Bauelementen infolge Bruchs erheblich eingeschränkt.

Aufgabe der vorliegenden Erfindung ist es, eine Möglichkeit anzugeben, wie Halbleiterbauelemente im Materialsystem von GaAs mit einer höheren Ausbeute an funktionsfähigen Exemplaren hergestellt werden können.

Diese Aufgabe wird mit dem Bauelement mit den Merkmalen des Anspruchs 1 bzw. mit dem Verfahren mit den Merkmalen des Anspruchs 5 gelöst. Ausgestaltungen ergeben sich aus den abhängigen Ansprüchen.

Bei dem erfindungsgemäßen Bauelement ist ein Substrat aus GaAs vorhanden, das eine Dicke d von höchstens etwa 10 µm bis etwa 30 µm aufweist. In dieser Dicke besitzt das Material Eigenschaften einer Folie, insbesondere eine Flexibilität und Dehnbarkeit, die ein Brechen des Substrates verhindern. Eine aufgebrachte, z. B. aufgedampfte oder aufgestäubte, Metallisierung kann bei bestimmten Ausführungsformen vorhanden sein, um die Reißfestigkeit des Substrates zu erhöhen und die Flexibilität in gewünschtem Umfang zu vermindern, insbesondere, damit auf dem Substrat vorhandene integrierte Halbleiterbauelemente keinen zu großen mechanischen Spannungen ausgesetzt werden.

Die Struktur eines mit einem solchen Substrat versehenen Bauelementes kann gegenüber herkömmlichen Halbleiterbauelementen deutlich verbessert sein, da in ein Substrat der angegebenen Dicke äußerst kleine Löcher für Durchkontaktierungen (via holes) in Gestalt von so genannten Micro Via Holes geätzt werden können. Der Durchmesser eines Micro Via Holes kann 1 µm oder weniger betragen. Eine vertikale Kontaktierung durch das Substrat hindurch mittels elektrisch leitender Kontaktlochfüllungen, die in diese Löcher eingebracht werden, ist somit problemlos auch in sehr kleinen Dimensionen möglich. Ferner ergeben sich verbesserte thermische Eigenschaften der Bauelemente, da die im Betrieb entstehende Wärme durch ein dünnes Substrat besser auf die von dem integrierten Bauelement abgewandte Seite des Substrates abgeführt werden kann. Die geringere Abmessung gegenüber bisherigen Halbleiterbauelementen und die besagte gute Wärmeableitung ermöglichen die Verwendung kleinerer Gehäuse.

Die beigefügten Figuren zeigen Beispiele für die Ausführungsformen des Bauelementes.

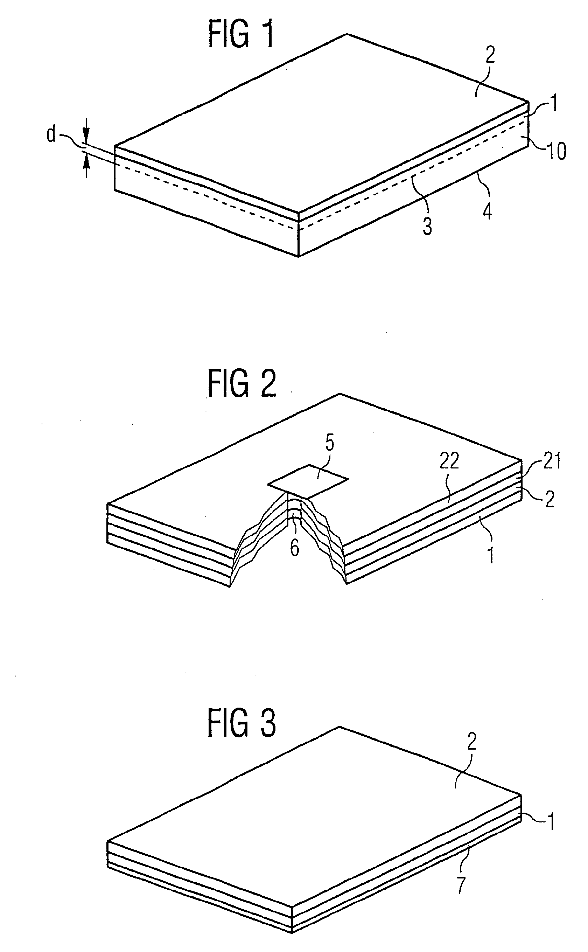

In Figur 1 ist ein Substrat 10 aus GaAs in ursprünglicher Dicke dargestellt, auf dem in diesem Beispiel nur eine epitaktisch aufgewachsene Schicht 2 vorhanden ist. Es können mehrere Schichten vorhanden sein, die je nach der Funktionsweise des Bauelementes unterschiedlich strukturiert, mit elektrisch leitend dotierten Bereichen und Kontakten versehen und mittels strukturierter Metallisierungsebenen zu Schaltungen verdrahtet sein können. Die Einzelheiten entsprechen an sich bekannten Bauelementen und sind hier nicht dargestellt. Von der Rückseite 4 ist das Substrat 1 des erfindungsgemäßen Bauelementes bis zu einer rückseitigen Fläche 3 (gestrichelt eingezeichnet) auf eine Dicke d von etwa 30 µm, vorzugsweise etwa 10 µm, gedünnt.

Figur 2 zeigt ein anderes Ausführungsbeispiel, bei dem mehrere aufgewachsene Schichten 2, 21, 22 vorhanden sind, deren oberste mit einer Kontaktfläche 5 versehen ist. Diese Kontaktfläche 5 aus einem elektrisch leitenden Material, vorzugsweise einem Metall, befindet sich über einem Kontaktloch 6, das hier in einer Schnittansicht dargestellt ist, und in elektrisch leitender Verbindung mit einer elektrisch leitenden Kontaktlochfüllung, die in das Kontaktloch 6 eingebracht ist. Als Material der Kontaktlochfüllung kann z. B. das auch sonst für diesen Zweck verwendete Wolfram dienen, wobei allerdings der Durchmesser des Kontaktloches 6 und damit der Durchmesser der mit der Kontaktlochfüllung gebildeten Durchkontaktierung wesentlich geringer ist als bei herkömmlichen ungedünnten Bauelementen, vorzugsweise höchstens 1 µm.

Figur 3 zeigt eine weitere Ausführungsform, bei der die Rückseite des mit einer aufgewachsenen Schicht 2 versehenen gedünnten Substrates 1 eine aufgedampfte oder aufgestäubte Metallisierung 7 aufweist.

Das erfindungsgemäße Bauelement wird vorzugsweise hergestellt, indem von einer Hauptseite eines GaAs-Substrates her in dem Substratmaterial mindestens ein elektrisch leitend dotierter Bereich ausgebildet wird und/oder auf das Substrat mindestens eine Schicht aus Halbleitermaterial epitaktisch aufgewachsen wird und danach das Substrat durch Dünnschleifen von der gegenüberliegenden Hauptseite her auf eine Dicke unterhalb der angegebenen Werte gebracht wird. Die Bezeichnung Dünnschleifen umfasst hierbei auch das chemisch-mechanische Polieren (chemical-mechanical polishing, CMP) oder Läppen.

Bezugszeichenliste
- 1: Substrat
- 2: epitaktisch aufgewachsene Schicht
- 3: rückseitige Fläche
- 4: Rückseite
- 5: Kontaktfläche
- 6: Kontaktloch
- 7: Metallisierung
- 10: Substrat
- 21: aufgewachsene Schicht
- 22: aufgewachsene Schicht

## Patentansprüche

1. Bauelement auf einem Substrat (1) aus GaAs, bei dem das Substrat eine Dicke (d) von höchstens 30 µm aufweist.

2. Bauelement nach Anspruch 1, bei dem das Substrat (1) eine Dicke (d) von höchstens 10 µm aufweist.

3. Bauelement nach Anspruch 1 oder 2, bei dem Löcher (6) in dem Substratmaterial mit einem Durchmesser von höchsten 1 µm vorhanden sind, die das Substrat (1) durchdringen.

4. Bauelement nach Anspruch 3, bei dem die Löcher (6) mit elektrisch leitfähigem Material als Kontaktlochfüllung gefüllt sind.

5. Verfahren zur Herstellung eines Bauelementes auf einem Substrat aus GaAs, bei dem von einer Hauptseite des Substrates (10) her
in dem Substrat mindestens ein elektrisch leitend dotierter Bereich ausgebildet wird und/oder auf das Substrat mindestens eine Schicht (2) aus Halbleitermaterial epitaktisch aufgewachsen wird und
das Substrat danach von der gegenüberliegenden Seite auf eine Dicke (d) von höchstens 30 µm gedünnt wird.

6. Verfahren nach Anspruch 5, bei dem
in das gedünnte Substrat (1) Löcher (6) geätzt werden, die als Durchkontaktierungen vorgesehen sind.
